# EUROPEAN PATENT APPLICATION

(11) **EP 0 851 491 A2**
(43) Date of publication of application: **01.07.1998**
(21) Application number: 97122827.5
(22) Date of filing: 23.12.1997
(51) Int. Cl.: H01L 23/522, H01L 23/532, H01L 21/768

(54) **Semiconductor device having multilevel interconnection structure and manufacturing method thereof**

(30) Priority: 25.12.1996 JP 344726/96
(71) Applicant: NEC CORPORATION, Tokyo (JP)
(72) Inventor: Usami, Tatsuya, Minato-ku, Tokyo (JP)
(74) Representative: Glawe, Delfs, Moll & Partner

(57) **Abstract**

In a semiconductor device with a multilevel interconnection structure according to the present invention, a dielectric constant between interconnections is lowered and the reliability and performance of the device is enhanced. The semiconductor comprises a plurality of interconnections formed on a first insulating-film, a second insulating-film formed on the side walls of each of the plurality of interconnections, a plurality of grooves formed in the first insulating-film between the plurality of interconnections, and a third insulating-film, with smaller dielectric constant than that of the first and second insulating-film, formed in each of the plurality of grooves which each is between the plurality of interconnections, and directly formed on the first insulating-film.

## Description

### BACKGROUND OF THE INVENTION

The present invention relates to a semiconductor device having multilayer structure and manufacturing method thereof, particularly relating to a compact wiring-connection structure and forming method thereof.

### Description of the Related Art

In accordance with the fact that the size of semiconductor devices have been decreased year by year, more compact multilayer interconnections become essential to construct semiconductor devices. Currently, in order for the inter-layer insulating-film of the semiconductor devices using such multilayer interconnections to reduce the parasitic capacities between the neighboring upper and lower layer and between interconnections in the same layer, insulating-films in silicon oxide film systems, which have a relatively small dielectric constant and steady quality, are used in the majority of systems.

The width of an interconnection in the lower layer and the distances between interconnections are reduced in accordance with the shrinking of the semiconductor device, however, some extent of interconnection of these areas is essential to avoid increasing the resistance of the interconnections. Accordingly, the aspect ratio (height of an interconnection / width of an interconnection ) of the interconnection layer and the aspect ratio (height of an interconnection / distance between interconnections ) between interconnections are both expanded. Also, parasitic capacities between interconnection layers may increase drastically to cause the decrease of the signal transmission velocity, and crosstalk between interconnection layers may frequently occur(a phenomenon of occurrence of signal noises between neighboring interconnection layers ).

In addition, if there are large bumps on the surface of an interlayer insulating-film, compact resist patterns cannot be formed due to shortage of the focus margin in the photo-lithography approach during the formation of the upper interconnection layer. Even if the compact resist patterns can be formed, the breaking of interconnections in the upper interconnection layer would occur and the interconnection material would be left on the bumps after an etching process is performed because of the large bumps. Thus, it is essential that the surface of the inter-layer insulating-film is smooth.

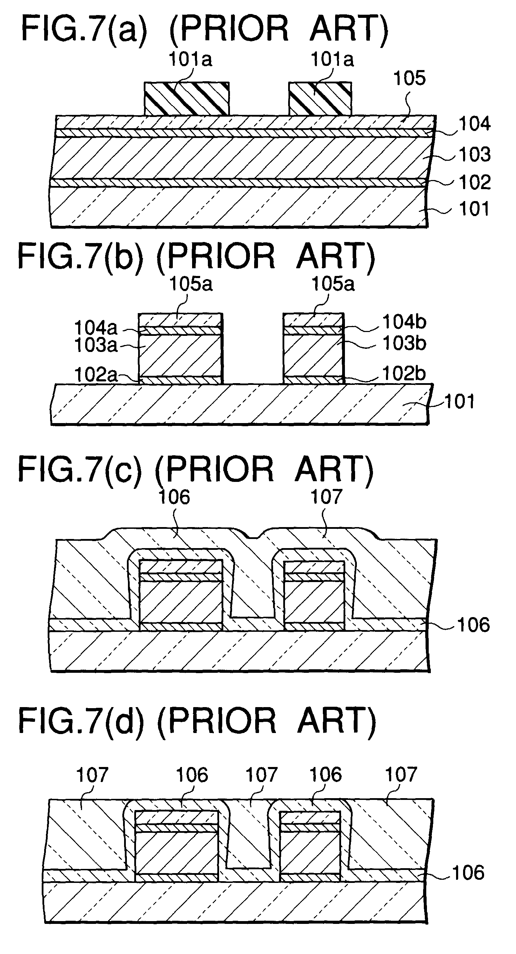

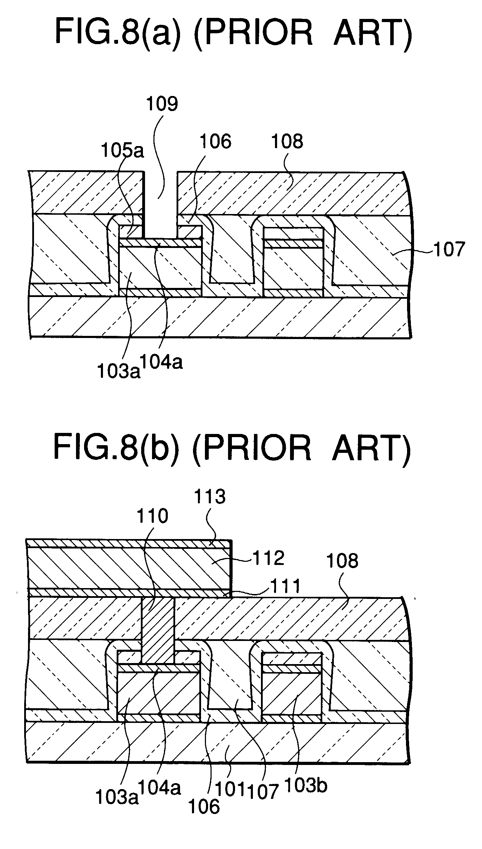

In order to solve problems on such compact multilayer interconnections, a variety of approaches have been proposed to apply an inter-layer insulating-film with a low dielectric constant . For instance, there is the technology as disclosed in a monthly issue of 'Semiconductor World', PP. 26 - 30, Aug., 1995. The technology will now be explained with reference to drawings. Figs. 7 and 8 show cross-sections of a conventional interconnection structure of two layers, which are placed in the order of the fabricating process.

As shown in Fig. 7(a ), thick insulating-film 101 is formed on the surface of silicon substrate. Next, a first barrier metal film 102, a first interconnection metal film 103, and a second barrier metal film 104 are deposited and formed on the thick insulating-film 101. Following this, a mask insulating-film 105 are formed on the second barrier metal film 104, and then resist mask 101a are placed on top using the photo-lithography technology.

After that, using the resist mask 101a, which is an etching mask, the mask insulating-film 105 is subjected to RIE (Reactive Ion Etching ) to form hard mask layers 105a and 105b. Resist mask 101a is subjected to elimination, and after which the second barrier metal film 104, the first interconnection metal film 103 and the first barrier metal film 102 are subjected to dry-etching using the masks of the hard mask layers 105a and 105b. With the above process, as shown in Fig. 7(b ), a first barrier metal layers 102a and 102b are formed on the thick insulating-film 101, and on top of these first interconnection layers 103a and 103b are subsequently formed on top. After that, second barrier metal layers 104a and 104b are formed on the first interconnection layers 103a and 103b.

Next, as shown in Fig. 7(c ), a protective insulating-film 106 is formed to cover the whole surface, after which an organic SOG film 107 is formed. Further, for the protective insulating-film 106, an insulating-film with excellent insulation performance and moisture-proofing is used. For example, such a silicon oxide film as deposited using the plasma chemical vapor deposition method is used. In contrast to the performance described above, the dielectric constant of the organic SOG film 107 is smaller than that of silicon oxide film, and in general the quality of its moisture-proofing is not sufficient.

Next, as shown in Fig. 7(d ), the organic SOG film 107 is subjected to polishing and leveled. The protective insulating-film 106 functions as an etching prevention film. With the process described above, a first inter-layer insulating-film made up of the protective insulating-film 106 and organic SOG film 107 are formed. Further, the relative dielectric constant of the organic SOG film 107 is approximately 3, which means low dielectric constant. In addition, the relative dielectric constant of the silicon oxide film is approximately 4.

Next, As shown in Fig. 8(a ), a second inter-layer insulating-film 108 is formed on the first inter-layer insulating-film. Thereafter, a through-hole 109 extending to the second barrier metal layer 104a is made in the second inter-layer insulating-film 108, the protective insulating-film 106 and the hard mask layer 105a which is positioned over the first interconnection layer103a.

After this, as shown in Fig. 8(b ), a metal plug 110 plugs the through-hole to make a connection to the second barrier metal layer 104a, and thereby a third barrier metal layer 111, a second interconnection layer 112, and a firth barrier metal layer 113 are formed, respectively.

With the interconnection structure described above, the neighboring first interconnection layers 103a and 103b, are formed on the thick insulating-film 101 and sandwich the insulating-film made up of the protective insulating-film 106 and the organic SOG film. Thus, a capacitance between the first interconnection layers 103a and 103b is reduced by the organic SOG film 107 having a low dielectric constant.

However, with the above-mentioned conventional technology, since the protective insulating-film 106 with a highly dielectric constant is also formed on the bottom between the first interconnection layers 103a and 103b, thus a capacitance of the portion between them is not reduced. constant. In addition, parasitic capacities result from the thick insulating-film 101 connecting between the bottoms of the interconnections, or parasitic capacities caused by the fringing effect were not minimized.

Further, with the conventional technologies, since the protective insulating-film 106 such as a silicon oxide film is formed after the formation of interconnections, it can easily develop into a overhang shape. Thus, it is difficult to fill the insulating-film 107 with a low dielectric constant into such a narrow region. In addition, the reliability of the interconnection structure is decreased. Obviously, the narrower the interconnection distance becomes in accordance with the compact structure in semiconductor devices, the more these problems may occur. Since the reliability on the interconnection structure is decreased, there is a limitation to make an inter-layer insulating film with a low dielectric constant being imposed.

### Summary of the invention

Accordingly, the objective of the present invention is to provide an interconnection structure and manufacturing method thereof, which enhances the reliability and performance of the compact interconnection structure, and which can correspond to the compact multilayer interconnections.

According to a first aspect of the present invention, the foregoing object is attained by providing a semiconductor device comprising: a semiconductor substrate; a first insulating-film; a plurality of interconnections formed side by side on the first insulating-film; a plurality of second insulating-films formed on respective side walls of the plurality of interconnections; and a third insulating-film, with smaller dielectric constant than that of said first insulating-film and said plurality of second insulating-films, which is directly formed on said first insulating-film between said side walls of said plurality of interconnections.

Further, according to a second aspect of the present invention, the foregoing object is attained by providing an manufacturing method of manufacturing a semiconductor device, comprising the steps of: forming a first insulating-film on a semiconductor substrate; forming an interconnection film on said first insulating-film; forming a second insulating-film on said interconnection film; forming a plurality of hard mask layers by patterning said second insulating film; forming a plurality of interconnections by patterning said interconnection film using said hard mask layers as a mask; selectively forming a plurality of side wall insulating-films on the side walls of each of said plurality of interconnections; and
directly forming a third insulating-film, with smaller dielectric constant than that of said first and second insulating-films, and said plurality of side wall insulating-films, on said first insulating-film between said plurality of interconnections.

According to the present invention, since an insulating-film with a highly dielectric constant is not formed on the bottom between interconnections, the parasitic capacities between the interconnections are reduced.

### Brief description of the present invention

The above and other objects, advantages and features of the present invention will be more apparent from the following description taken in conjunction with the accompanying drawings, in which:
Fig. 1 shows a cross-section diagram showing the interconnection portion in order to explain the first embodiment of the present invention;
Fig. 2(a )-2(d ) shows cross-section diagrams arranged in order of the manufacturing process of the first embodiment according to the present invention;
Fig. 3(a )-(c ) shows cross-section diagrams arranged in order of the manufacturing process of the first embodiment according to the present invention;
Fig. 4 shows a cross-section diagram showing the interconnection portion in order to explain the second embodiment of the present invention;
Fig. 5(a )-5(c ) shows cross-section diagrams arranged in order of the manufacturing process of the second embodiment of the present invention;
Fig. 6(a )-6(b ) shows cross-section diagrams arranged in order of the manufacturing process of the second embodiment of the present invention;
Fig. 7(a )-7(d ) shows cross-section diagrams arranged in order of the manufacturing process in order to explain the conventional art; and
Fig. 8(a )-8(b ) shows cross-section diagrams arranged in order of the manufacturing process in order to explain the conventional art.

### Description of the preferred embodiments

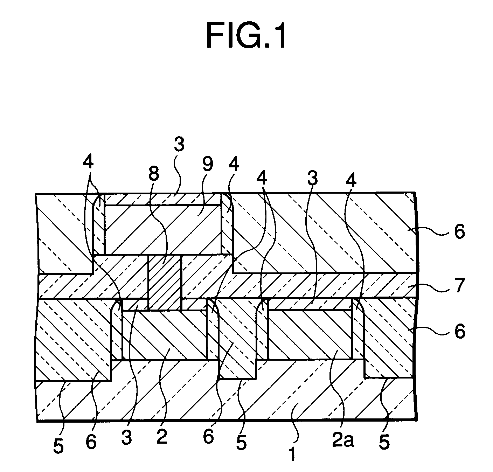

As shown in Fig. 1, several lower layer interconnections 2 and 2a having a thickness of approximately 600 nm are formed on a first inter-layer insulating-film 1 which is formed on the semiconductor substrate such as a silicon substrate. A distance between the interconnections 2 and 2a is approximately 30 nm. A hard mask layer 3 having a thickness of approximately 200 nm such as a silicon oxide film is formed on the upper surface of the lower layer interconnections 2 and 2a. Also, side-wall insulation layers 4 with so-called taper shape, or a shape such that the width of the upper portion is narrower than that of the lower portion, is placed on the side-walls of the lower layer interconnections 2 and 2a. The side-wall insulation layers 4 are made of, for example, a silicon oxide film. Groove 5 having a depth of approximately 30 nm are formed in the first inter-layer insulating-film between the lower layer interconnections.

An insulating-film 6 with a low dielectric constant is directly formed on the first inter-layer insulating-film 1 and between the lower layer interconnections 2 and 2a. The insulating-film 6 is also formed on the first inter-layer insulating film 1 and between the other interconnections and the interconnection 2 or 2a. The first inter-layer insulating-film 1 is made of, for example, a silicon oxide film, and its relative dielectric constant is approximately 4. In contrast, the insulating-film 6 with a low dielectric constant is made of, for example, an organic insulation film, and its relative dielectric constant is set in such a way that it is smaller than that of the first inter-layer insulating-film. Herein, a dielectric constant of the insulating-film 6 is approximately 2.5.

A second inter-layer insulating-film 7 is formed to cover the lower interconnection layer, which has been formed earlier. Thereafter, a metal plug 8 is formed in a predetermined region of the second inter-layer insulating-film 7 and electrically connected to the lower layer interconnection 2. An upper layer interconnection 9 is formed on the second inter-layer insulating-film 7 so that it is electrically connected to the metal plug 8. Herein, the second inter-layer insulating-film 7 is made of, for example, a conventional silicon oxide film with high moisture-proofing quality.

In the same manner as the lower layer interconnection described above, the hard mask layer 3 is formed on the upper surface of the upper layer interconnection 9, and side-wall insulation layers 4 are formed on the side walls of the upper layer interconnection 9. grooves are formed on the second inter-layer insulating film 7 between the upper layer interconnections 9, and the insulating-film 6 with a low dielectric constant formed between them.

According to the interconnection structure of the first embodiment, a parasitic capacitance between the interconnections 2 and 2a is reduced. A value of the parasitic capacitance becomes about 90 percent of a parasitic capacitance between the interconnections 103a and 103b of the prior art shown in Fig.7 and Fig. 8. Thus, for reducing the parasitic capacitance between interconnections, it is preferable taht the depth of the grooves is about 20 percent of a thickness of interconnections.

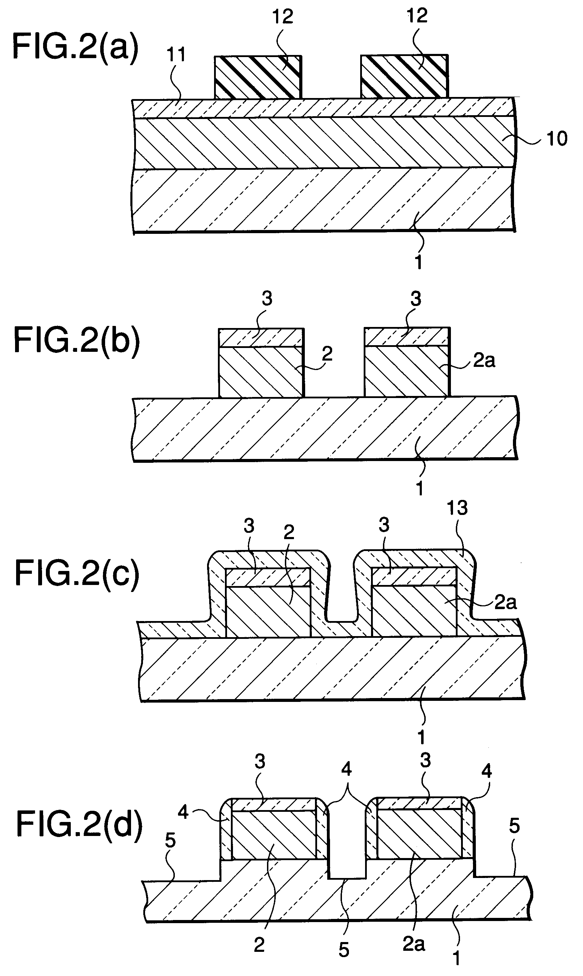

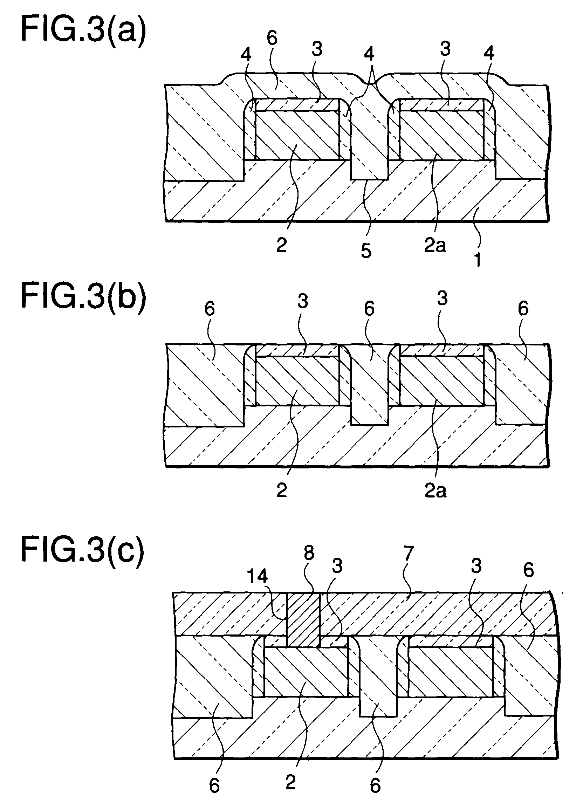

Next, a manufacturing method for the aforementioned interconnection structure will now be described with reference to Figs. 2 and 3. As shown in Fig. 2(a ), the first inter-layer insulating-film 1 such as a silicon oxide film is formed on a silicon substrate. An interconnection metal film 10 is formed on the first inter-layer insulating-film 1. Herein, the interconnection metal film 10 is an alloy film such as an aluminum /copper (AlCu ) alloy with its thickness of 500 nm or a laminated metal film such as the combination of a titanium (Ti ), a titanium nitride (TiN ) and an aluminum/copper alloy, which can be deposited using the sputtering approach.

Next, a mask insulating-film 11 is formed on the interconnection metal film 10. The mask insulating-film 11 is a silicon oxynitride film with the thickness of 300 nm deposited using the plasma CVD (Chemical Vapor Deposition ) method. Resist masks 12 are then formed using the photolithography technology. Herein, the pattern interval of the resist masks 12 is set of approximately 0.3 µm.

Next, as shown in Fig. 2(b ), the mask insulating-film 11 is subjected to RIE (Reactive Ion Etching ), using the resist masks 12 as an etching mask, to form hard mask layers 3. Herein, For a reactive gas for RIE, the mixed gas of CF4 and O2 is used. Thereby, the resist masks 12 are eliminated and the interconnection metal film 10 is subjected to RIE to be patterned using the hard mask layers 3 as a mask. In this manner, the lower layer interconnections 2 and 2a are formed. Herein, composing the reactive gas for RIE is the mixed gas of Cl2, BCl3 and CF4.

Next, as shown in Fig. 2 (c ), a side wall insulating-film 13 is formed to cover the hard mask layer, the hard mask layer 3 and the first inter-layer insulating-film 1. The side wall insulating-film 13 is a silicon oxynitride film with the thickness of 300 nm deposited using the plasma CVD method. Herein, the side wall insulating-film 13 forms a overhang shape the same as that of the protective insulating-film 106 as shown in Figs. 7 and 8, which show conventional arts.

Next, by highly anisotropic RIE, etching, or etching back is processed over the whole surface. Herein, for the reactive gas for RIE, the mixed gas of CF4 and O2 is used. Side wall insulation layers 4 are formed through the etching process on the side walls of the lower layer interconnections 2 and 2a as shown in Fig. 2 (d ). The side wall insulation layers 4 formed through the above-mentioned manner uses a taper shape.

Next, as shown in Fig. 2 (d ), the surface of the first inter-layer insulating-film 1 is subjected to RIE using the hard mask layers 3 and side wall insulation layers 4 as an etching mask. In this process, grooves 5 are formed to be with the depth of approximately 0.3 µm. For the reactive gas for RIE, the mixed gas of CH2F2 and CF4 is used.

Next, as shown in Fig. 3 (a ), an insulating-film 6 with a low dielectric constant is formed on the whole surface. A solution to form the organic SOG film is applied to the entire surface. The solution is filled into the grooves 5 formed in the first inter-layer insulating-film 1, and filled between the lower layer interconnections 2 and 2a covered with the hard mask layers 3 and side wall insulation layers 4. The solution is also filled between the other interconnections and the interconnection 2
or 2a. Thereafter, the applied solution is subjected to the heat treatment for thermoset so that the aforementioned organic SOG film is formed. The relative dielectric constant of the organic SOG film formed earlier is less than 3.

Next, the organic SOG film, is composed of the insulating-film 6 with a low dielectric constant is polished to be leveled using the CMP method. Thereby, unnecessary regions of the insulating-film 6 are eliminated, as shown in Fig. 3 (b ), and the insulating-film 6 with a low dielectric constant which has been leveled is now formed between the lower layer interconnections 2 and 2a. Herein, the hard mask layer 3 functions as an etching prevention for the CMP.

Next, as shown in Fig. 3 (c ), a second inter-layer insulating-film 7 is formed to cover the hard masks 3 and the insulating-film 6 with a low dielectric constant. Herein, the second inter-layer insulating-film 7 is a silicon oxide film with the thickness of 500 nm deposited using the plasma CVD method.

Next, A through-hole 14 is formed in the predetermined region of the hard mask layers 3 and the second inter-layer insulating-film 7, and a metal plug 8 is filled into the through-hole 14 to be electrically connected to the lower layer interconnection 2. Herein, the metal plug 8 is formed by generating a tungsten film using the CVD method, and by polishing using the CMP method.

Next, in the same manner as shown in Fig. 1, an interconnection upper layer is formed. Herein, the forming method is the same as that of the aforementioned interconnection lower layer. That is, hard mask layers 3 are formed on upper layer interconnections, and side wall insulation layers 4 are then formed on the side walls of tue upper layer interconnections. Also, grooves are formed in the second inter-layer insulating-film 7. An insulating-film 6 with a low dielectric constant is filled between the upper layer interconnections.

As described above, according to the present invention, since an insulating-film with a highly dielectric constant is not formed on the bottom between interconnections, the parasitic capacities between the interconnections are reduced. In addition, according to the present invention, grooves are formed on the inter-layer insulating-film, which is a ground between interconnections, and an insulating-film with a low dielectric constant is deposited into the grooves. Thereby, parasitic capacities resulted from the insulating-film between the bottoms of the interconnections, or parasitic capacities resulting from the fringing effect are largely decreased.

Further, since the surfaces of the side wall insulation layers formed on the side walls of interconnections are formed with a taper shape by the etching-back process, an insulation layer with a low dielectric constant can easily deposit into regions with a narrow interconnection interval.

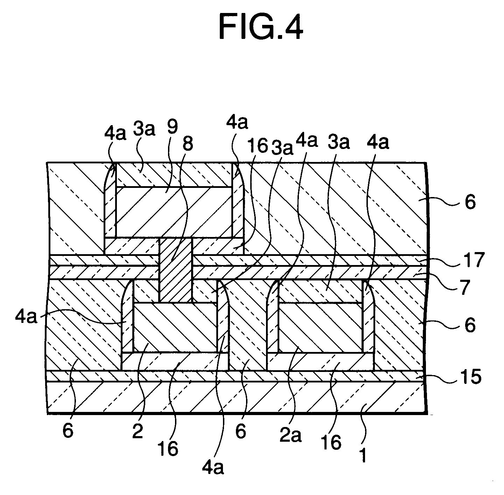

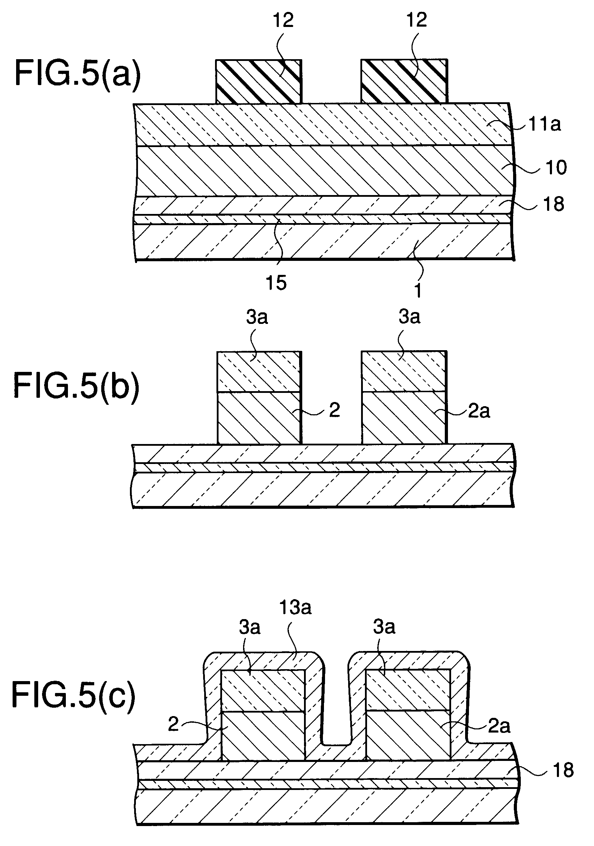

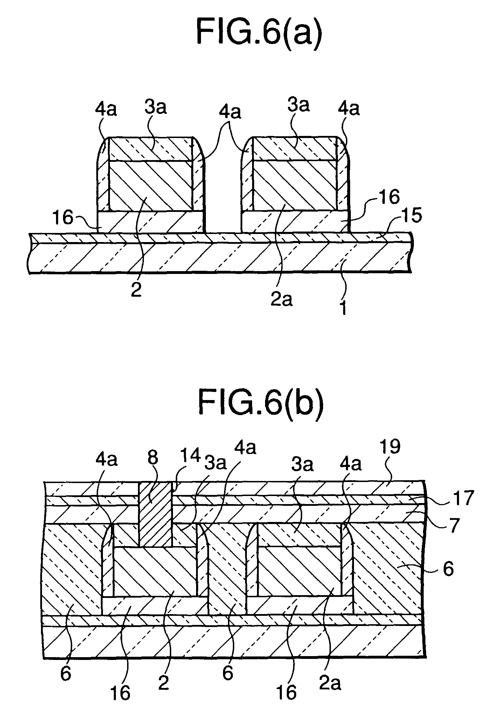

Next, a second embodiment of the present invention will now be described. Fig. 4 is a cross-section diagram showing the interconnection portion of the second embodiment. Fig. 5 and 6 are cross-sectional diagrams showing the manufacturing process to manufacture the interconnection portion. Herein, the same functional portions are attached with the same reference numerals as those of the first embodiment.

As shown in Fig. 4, a first prevention film 15 with a thin thickness is formed on the first inter-layer insulating-film 1 formed on the surface of a semiconductor substrate such as a silicon substrate. Intermediate insulation films 16 are formed on the first prevention film 15. Several lower layer interconnections 2 and 2a are formed on the intermediate insulation layers 16.

In the same manner as that of the first embodiment, hard mask layers 3 are formed on the lower layer interconnections 2 and 2a, and on the side walls of which a side wall insulation layers 4a are formed. Herein, the side wall insulation layers 4a are made of an inorganic insulating-film with a taper shape.

Insulating-films 6 with a low dielectric constant is formed to fill the region between the lower layer interconnections 2 and 2a, the regions between the other interconnections and the interconnection 2
or 2a and the region between the intermediate insulation layers 16.

In order to cover the formed interconnection lower layer, a second inter-layer insulating-film 7,a second prevention film 17 and intermediate insulation layers 16 are laminated. A metal plug 8 is formed in the predetermined region of the laminated insulating-film to be electrically connected to the lower layer interconnection 2. An upper layer interconnection 9 is formed on the intermediate insulation layer 16 to be electrically connected to the metal plug 9.

In the same manner as those of the aforementioned interconnection layers, a hard mask layer 3a is formed on the upper surface of the upper layer interconnection 9, and on the side walls of which a side wall insulation layers 4a are formed. An insulating-film 6 with a low dielectric constant is formed between the upper layer interconnections.

A manufacturing method of the aforementioned interconnection structure will now be described with reference to Figs. 5 and 6.

As shown in Fig. 5 (a ), a first prevention film 15 is formed on the first inter-layer insulating-film 1, which is a silicon oxide film, and a first intermediate insulating-film 18 is formed on the first prevention film 15 using the CVD method. Herein, the first prevention film 15 is a silicon nitride film with the thickness of approximately 50 nm. Also, the first intermediate insulating-film 18 is a silicon oxide film with the thickness of approximately 300 nm. Herein, a silicon oxynitride film can be used for the first prevention film 15 in stead of the silicon nitride film.

Next, an interconnection metal film 10 is formed on the first intermediate insulating-film 18. Herein, the interconnection metal film 10 is a metal film such as described in the first embodiment.

Thereafter, a mask insulating-film 11a is formed on the surface of the interconnection metal film 10. Herein, the mask insulating-film 11a is a silicon oxide film with the thickness of 800 nm deposited using the plasma CVD method. In the same manner as that of the first embodiment, resist masks 12 are formed using the photolithography technology. Herein, the pattern interval of the resist masks 12 are approximately 0.5µm.

Next, as shown in Fig. 5 (b ), the mask insulating-film 11a is subjected to RIE using
the resist masks 12 as a etching mask to form hard mask layers 3a. Herein, the CHF3 gas is used for the reactive gas for RIE. Thereby, the resist masks 12 are eliminated, and in the same manner as that of the first embodiment the interconnection metal film 10 is subjected to RIE to be patterned using the hard mask layers 3a as a mask.

Thereafter, as shown in Fig. 5 (c ), a side wall insulating-film 13a is formed to cover the lower layer interconnections 2 and 2a, the hard mask layers 3a and the first intermediate insulating-film 18. The side wall insulating-film 13a is a silicon oxide film with the thickness of approximately 200 nm deposited using the plasma CVD.

Next, as described in the first embodiment, the entire surface is etching-back through the isotropic RIE. Herein, the CHF3 gas is used for the reactive gas for RIE. The first intermediate insulating-film 18 between interconnections is also eliminated through the etching-back process Herein, the first prevention film 15 plays a role of preventing the first inter-layer insulating-film 1 from being etched through the reverse-etching process.

In this manner, as shown in Fig. 6 (a ), a hard mask layers 3a are formed on the upper surface of the lower layer interconnections 2 and 2a, and on the side walls of which side wall insulation layers 4a are formed. Herein, the formed side wall insulation layers 4a form a taper shape.

Next, as shown in Fig. 6 (b ), insulating-films 6 with a low dielectric constant, which are leveled in the same manner as that of the first embodiment, are formed on the whole surface. Further, an organic insulating-film with a moisture absorbing property such as a polyimide film can be used for the insulating-films 6 with a low dielectric constant. Furthermore, an inorganic insulating-film such as SiOF and SiBN also can be used

Next, as shown in Fig. 6 (b ), the laminated insulating film of a second inter-layer insulating-film 7, a second prevention film 17 and a second intermediate insulating-film 19 is formed to cover the hard mask layers 3a and the insulating-films 6. Herein, the second inter-layer insulating-film 7 is a silicon oxide film with the thickness of approximately 200 nm deposited using the plasma CVD method, while the second prevention film 17 is a silicon nitride film with the thickness of approximately 50 nm. The second intermediate insulating-film 19 is a silicon oxide film with the thickness of approximately 300 nm.

Thereafter, a through-hole 14 is formed in the predetermined regions of the hard mask layers 3a and the aforementioned laminated insulating-films, and a metal plug 8 is filled into the through-hole to make an electrically direct contact to the lower layer interconnection 2.

Next, as described with reference to Fig. 4, an interconnection upper layer is formed. Herein, the forming method is the same as that of forming the aforementioned interconnection lower layer. That is, an upper layer interconnection 9 is formed on the second intermediate insulation layer 19, and the hard mask layers 3a are formed on the surface of the upper layer interconnection 9, and on the side wall of which side wall insulation layers are formed. Thereafter, an insulating-film 6 is filled between the upper layer interconnections.

In this case, in the same manner as that of the first embodiment, the insulating-film with a low dielectric constant formed between interconnections is deposited into the deep region form the bottom of the interconnections. Thus, the parasitic capacities formed between the bottoms of neighboring interconnections, or parasitic capacities formed between the edges of the interconnections are also reduced. Further, according to the second embodiment, a fixed groove depth is formed using a prevention film such as the first prevention film 15 or the second prevention film 17. Thus, the uniformity of the depths of the grooves in the semiconductor substrate is greatly improved compared with that of the first embodiment.

Further, the insulating-film with a low dielectric constant according to the present invention can be, for example, HSQ (Hydrogen Silsesquioxane), polyarylether, flurorine polyarylether, inorganic polysilazane, BCB (BenzoCycloButene ), MSQ (Methyl Silsesquioxane), fluorine polyimide, plasma CF polymer, plasma CH polymer, teflon AF (trade mark), poly paraxylylene-N, poly paraxylylene-F, and naphthalene-N, other than those described in the first embodiment.

Furthermore, the first inter-layer insulating-film, the second inter-layer insulating film, the hard mask layer, the side wall insulating-film and the prevention film according to the present invention cannot be limited within the aforementioned materials, but can be an insulating-film such as the plasma silicon oxide film, the plasma silicon nitride film, the plasma silicon oxynitride film, the plasma silicon oxyboron film, the plasma boron nitride film, the plasma silicon boron nitride film, and the ozone tetraehyl orthosilicate non-doped silicate glass (O3TEOS NSG ).

As described above, according to the present invention, since an insulating-film with a highly dielectric constant is not formed on the bottom between interconnections, the parasitic capacities between the interconnections are reduced. Further, the grooves are formed by eliminating a fixed depth of the region corresponding to the region between the interconnections, and the grooves as well as the region between the interconnections are filled with an insulating-film having a low dielectric constant. Therefore, parasitic capacities due to the fringing effect with respect to neighboring interconnections can be reduced, and parasitic capacities between interconnections can be greatly reduced. The more compact the interconnections become, the more apparent the effect becomes.

Further, according to the present invention, side wall insulating layers with a taper shape are formed on the side walls of the interconnections. Thus, it becomes easier to fill an insulating-film with a low dielectric constant into the narrow region between interconnections. Therefore, the reliability on the interconnection structure can be enhanced. The more compact the semiconductor device becomes, the more apparent the effect becomes.

As described earlier, according to the present invention, more compact semiconductor devices can be made easily; the performance of compact multilayer interconnections can be enhanced; and accordingly the reliability of the device is raised.

It is apparent that the present invention is not limited to the above-mentioned embodiments, but may be modified and changed without departing from the scope and spirit of the invention.

## Claims

1. A semiconductor device, comprising:
a semiconductor substrate;
a first insulating-film;
a plurality of interconnections formed side by side on the first insulating-film;
a plurality of second insulating-films formed on respective side walls of said plurality of interconnections; and
a third insulating-film, with smaller dielectric constant than that of said first insulating-film and said plurality of second insulating-films, which is directly formed on said first insulating-film between said side walls of said plurality of interconnections.

2. The semiconductor device as claimed in claim 1, wherein said plurality of second insulating-films are with taper shapes.

3. The semiconductor device as claimed in claim 1, wherein said first insulating-film comprises a plurality of grooves with a predetermined depth between said side walls of said plurality of interconnections, and said third insulating-film is formed into said plurality of grooves.

4. The semiconductor device as claimed in claim 3, wherein said first insulating-film comprises a fourth, fifth and sixth insulating-films formed in this order on said semiconductor substrate, and said third insulating-film is in contact with said fifth insulating-film at a bottom of said grooves.

5. A manufacturing method of manufacturing a semiconductor device, comprising steps of:
forming a first insulating-film on a semiconductor substrate;
forming an interconnection film on said first insulating-film;
forming a second insulating-film on said interconnection film;
forming a plurality of hard mask layers by patterning said second insulating film;
forming a plurality of interconnections by patterning said interconnection film using said hard mask layers as a mask;
selectively forming a plurality of side wall insulating-films on side walls of each of said plurality of interconnections; and
directly forming a third insulating-film, with smaller dielectric constant than that of said first and second insulating-films, and said plurality of side wall insulating-films, on said first insulating-film between said side walls of said plurality of interconnections.

6. The manufacturing method as claimed in claim 5,
further comprising the steps of:
forming a plurality of grooves in said first insulating-film between said side walls of said plurality of interconnections; and
forming said third insulating-film in said plurality of grooves.

7. The manufacturing method as claimed in claim 6, wherein said first insulating-film comprises fourth, fifth and sixth insulating-films formed in this order on said semiconductor substrate, and said plurality of grooves being formed to expose said fifth insulating-film.

8. The manufacturing method as claimed in claim 5, wherein said plurality of side wall insulating-films are with taper shapes.
